# EUROPEAN PATENT APPLICATION

(11) **EP 1 202 136 A2**
(43) Date of publication of application: **02.05.2002**
(21) Application number: 01125536.1
(22) Date of filing: 25.10.2001
(51) Int. Cl.: G03H 1/04, G11C 13/04

(54) **Spatial light modulator/demodulator and holographic recording/reproducing apparatus using the same**

(30) Priority: 31.10.2000 JP 2000332826
(71) Applicant: Pioneer Corporation, Meguro-ku, Tokyo (JP)
(72) Inventor: Tanaka, Satoru, Corporate Research & Develop. Lab., Tsurugashima-shi, Saitama 350-2288 (JP)
(74) Representative: Manitz, Finsterwald & Partner GbR

(57) **Abstract**

A spatial light modulator/demodulator and a hologram recording/reproducing apparatus permitting a reduction of size, for a photorefractive-material recording medium using the same. The hologram recording/reproducing apparatus has a reference light part for making a coherent recording reference light beam incident on a main surface of the recording medium, a part for making a coherent signal light beam modulated according to image data incident on the recording medium and intersect the recording reference light beam in an interior thereof, and generating a refractive index grating of a three-dimensional light interference pattern of the signal light beam and recording reference light beam, and a part for making a coherent reproducing reference light beam propagated coaxially and in a reverse direction to the recording reference light beam incident on the recording medium to cause a phase conjugate wave from the refractive index grating of the light interference pattern. A spatial light modulator/demodulator included in the part making the signal light beam incident has a plurality of mirrors having respective reflecting surfaces arranged in proximity to a plane, photoelectric converting elements each provided on the reflecting surface of the mirror, a drive mechanism for driving the mirrors to independently change an angle of the reflecting surface to the plane, and a substrate supporting the mirrors and the drive mechanism, and carrying an electric circuit for independently controlling the drive mechanism according to input image data and connected to the photoelectric converting elements to derive an output thereof. The plurality of mirrors modulates and reflects a coherent light beam according to digital image data to supply the signal light beam, and the photoelectric converting element detects image data focused by the phase conjugate wave.

## Description

### BACKGROUND OF THE INVENTION

### 1. Field of the Invention

The present invention relates to a spatial light modulator/demodulator and, furthermore, to a holographic recording/reproducing apparatus using the same.

### 2. Description of Related Art

As a digital information recording system utilizing the principle of hologram, there is a known holographic recording/reproducing apparatus utilizing a recording medium formed of a photorefractive material, i.e. so-called a holographic memory. In this system, information signals are recorded in terms of change in refractive index, onto a recording medium of a photorefractive material, such as a lithium-niobate single crystal.

Among conventional holographic recording/reproducing methods, there is a method configured to carry out recording and reproduction by the use of Fourier conversion.

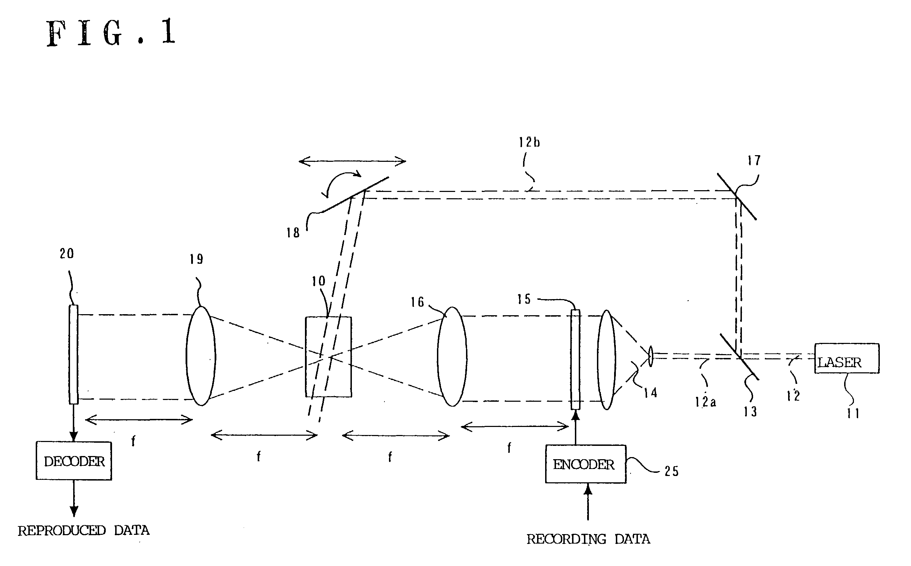

As shown in Fig. 1, in a conventional holographic recording/reproducing apparatus based on the so-called 4-F system, the beam of light 12 emitted from a light-beam source 11 is split into a signal light beam 12a and a recording reference light beam 12b by the beam splitter 13. The signal light beam 12a is magnified in beam diameter, by a beam expander 14 and illuminated as a collimated light to a spatial light modulator (SLM) 15. The SLM 15, such as a transmission-type TFT liquid crystal display (LCD) panel, receives as an electric signal the recording data converted in signal by an encoder and forms a light-and-darkness dot pattern on a plane. The signal light beam 12a, if passes the SLM 15, is optically modulated to contain a data signal component. The signal light beam 12a containing a dot-pattern signal component passes through a Fourier transforming lens 16 arranged to be spaced from the SLM 15 by its focal distance f, where its dot-pattern signal component is Fourier-transformed and focused into a recording medium 10. On the other hand, the recording reference light beam 12b split in the beam splitter 13 is guided into the recording medium 10 by mirrors 17, 18 to intersect the light path of the signal light beam 12a at the inside of the recording medium 10, thus forming a light interference pattern and recording as a change of refractive index.

In this manner, the diffraction light from the image data illuminated by a coherent collimated light is focused through the Fourier transforming lens so that diffraction light is changed into a distribution on its focal plane, or Fourier plane. The distribution as a result of Fourier transformation interferes with the coherent reference light to record an interference fringe thereof onto the recording medium placed in the vicinity of the focal point. When the record of the first page is complete, a rotary mirror 18 is rotated a predetermined amount and moved in parallel a predetermined amount in position so that the incident angle of the recording reference light beam 12b on the recording medium 10 is changed to record the second page by the same procedure. Angle-multiplex recording is carried out by sequentially performing the recording procedure described above.

During reproduction, on the other hand, inverse Fourier transformation is carried out to reproduce a dot-pattern image. In reproducing information, as shown in Fig. 1 the light path of the signal light beam 12a is cut off by the SLM 15 for example, to illuminate only the recording reference light beam 12b to the recording medium 10. During reproduction, in order to make incident the recording reference light beam 12b at the same angle as the recording reference light of upon recording the page to be reproduced, the mirror 18 is changed and controlled in position and angle by the combination of rotation of mirror and parallel movement. A reproduced light reproductive of a recorded light interference pattern appears at an opposite side of the recording medium 10 to the side illuminated by the recording reference light beam 12b. If the reproduced light is guided to and inverse-Fourier-transformed by an inverse Fourier transforming lens 19, the dot-pattern signal can be reproduced. Furthermore, with the dot-pattern signal is received by an imaging device or photodetector 20 which uses a CCD (Charge Coupled Device) or CMOS sensor arranged in the focal point, reconverted to an electric digital data signal and then sent to a decoder, the original data is reproduced.

In this manner, the conventional apparatus requires a high-performance Fourier transforming lens and inverse Fourier transforming lens. Furthermore, for recording/reproducing operation it is necessary to provide a high-performance paging control mechanism for controlling a reference light. By arranging a spatial light modulator and a photodetector array respectively on opposed two focal planes, light is modulated and demodulated to record/reproduce information. Accordingly, because of the necessity of providing optical systems in a symmetric analogous form sandwiching the recording medium, the size reduction of the system is greatly hindered thus posing a problem of difficulty in system's size reduction. Also, because information is transmitted through the architecture of a focusing optical system, a servo mechanism of a large scale is essentially required to adjust mutual alignment and the alignment of upon using a removable recording medium thus increasing the scale.

In the conventional holographic recording/reproducing apparatus, the positional accuracy between a pair of image input/output devices is of extreme importance. For example, where using a CCD device having 3 million pixels as an imaging device, the size of one pixel thereof is nearly 4 µm. In order to reduce the impediment due to the adjacent pixels in the above dimensions, there essentially is required a positioning accuracy of 0.5 pixel or smaller, or 2 µm or smaller, and 0.1 pixel or smaller, or 0.4 µm or smaller, for favorable image reception.

Furthermore, it is necessary that the magnification of the two-set lens system for the Fourier transformation - inversion Fourier transformation correctly matches the ratio between a pixel size and an imaging-device light-receiving part size of the spatial light modulator. This requires an accuracy of a lens magnification of 0.05% or less at the worst, in order to modulate a two-dimensional image having, for example, 1000 pixels × 1000 pixels by a spatial light modulator so that the light signal thereof is again received as an image of 1000 pixels × 1000 pixels by the photodetector array through the Fourier/inversion Fourier transforming lens. This requires an extremely high accuracy and hence manufacture of the lens is not easy.

Meanwhile, there is a reproducing method with a phase conjugate wave as one of the method of reducing the size of a holographic memory system. In order to realize a reproducing method with a phase conjugate wave, a reference light upon recording (described as reproducing reference light) that is phase-conjugative to the reference light upon recording (described as recording reference light) can be generated by a phase conjugation mirror. However, it is not easy to realize a phase conjugation mirror.

Furthermore, the reproducing method with a phase conjugate wave, during recording, carries out recording similarly to the conventional. However, during the reproduction, because of the use of a phase conjugate wave reproduced from the recording medium toward the spatial light modulator, it is necessary to guide a phase conjugate wave to a photodetector, such as a CCD, or the like by the provision of a beam splitter in front of the spatial light modulator. Therefore, difficuly in alignment of the optical-system still has been a major problem.

### OBJECT AND SUMMARY OF THE INVENTION

It is therefore an object of the present invention to provide a spatial light modulator/demodulator facilitating optical-system alignment and a size-reducible holographic recording/reproducing apparatus using the same.

A spatial light modulator/demodulator of the present invention comprises: a plurality of mirrors having respective reflecting surfaces arranged in proximity with each other on a plane; photoelectric converting elements each provided on a reflecting surface of the mirror; a drive mechanism for driving the mirrors to independently change an angle of the reflecting surface with respect to the plane; and a substrate supporting the mirrors and the drive mechanism, and carrying an electric circuit for independently controlling the drive mechanism according to input image data and connected to the photoelectric converting elements to derive an output thereof.

In the spatial light modulator/demodulator of the invention, the photoelectric converting element is provided nearly at a center of the reflecting surface.

In the spatial light modulator/demodulator of the invention, the photoelectric converting element is provided at an peripheral edge of the reflecting surface.

In the spatial light modulator/demodulator of the invention, an anti-reflection film is provided on the photoelectric converting element.

A holographic recording/reproducing apparatus of the present invention comprises:
a supporting part for attachably holding a recording medium formed of a photorefractive material;
a reference light part for making a coherent recording reference light beam incident on a main surface of the recording medium;
a signal light part for making a coherent signal light beam modulated according to image data incident on the recording medium and intersect the recording reference light beam in an interior thereof, and generating a refractive index grating of a three-dimensional light interference pattern of the signal light beam and recording reference light beam; and
a part for making a coherent reproducing reference light beam propagated coaxially and in a reverse direction to the recording reference light beam incident on the recording medium to cause a phase conjugate wave from the refractive index grating of the light interference pattern;
wherein
the signal light part includes a spatial light modulator/demodulator;
the spatial light modulator/demodulator comprising a plurality of mirrors having respective reflecting surfaces arranged in proximity to a plane, photoelectric converting elements each provided on the reflecting surface of the mirror, a drive mechanism for driving the mirrors to independently change an angle of the reflecting surface to the plane, and a substrate supporting the mirrors and the drive mechanism and carrying an electric circuit for independently controlling the drive mechanism according to input image data and connected to the photoelectric converting elements to derive an output thereof;
whereby the plurality of mirrors modulates and reflects a coherent light beam according to digital image data to supply the signal light beam, and the photoelectric converting element detects image data focused by the phase conjugate wave.

In the holographic recording/reproducing apparatus of the invention, the recording medium has a parallel plate form.

In the holographic recording/reproducing apparatus of the invention, the photoelectric converting element is. provided nearly at a center of the reflecting surface.

In the holographic recording/reproducing apparatus of the invention, the photoelectric converting element is provided at a peripheral edge of the reflecting surface.

In the holographic recording/reproducing apparatus of the invention, an anti-reflection film is provided on the photoelectric converting element.

### BRIEF DESCRIPTION OF THE DRAWINGS

Fig. 1 is a schematic structural view showing a conventional holographic recording system;
Fig. 2 is a schematic fragmentary cutaway plan view showing a spatial light modulator/demodulator of an embodiment according to the present invention;
Fig. 3A is a schematic perspective view showing a spatial light modulator/demodulator of the embodiment according to the invention;
Fig. 3B is a view schematically showing an address circuit embeded in the substrate 356 shown in Fig. 3A;
Fig. 4 is a schematic sectional view explaining the spatial light modulator/demodulator of the embodiment according to the invention;
Fig. 5 is a schematic perspective view explaining a spatial light modulator/demodulator of another embodiment according to the invention;
Fig. 6 is a schematic sectional view explaining the spatial light modulator/demodulator of the embodiment according to the invention;
Fig. 7 is a schematic sectional view explaining a holographic recording/reproducing apparatus of an embodiment according to the invention;
Fig. 8 is a schematic sectional view explaining a spatial light modulator/demodulator in an holographic recording/reproducing apparatus of another embodiment according to the invention;
Fig. 9 is a schematic sectional view explaining a recording/reproducing apparatus of another embodiment according to the invention; and
Fig. 10 is a schematic sectional view explaining a recording/reproducing apparatus of still another embodiment according to the invention.

### DETAILED DESCRIPTION OF THE PREFERRED EMBODIMENTS

Embodiments of the present invention will now be explained with reference to the accompanying drawings.

### <Spatial Light Modulator/Demodulator>

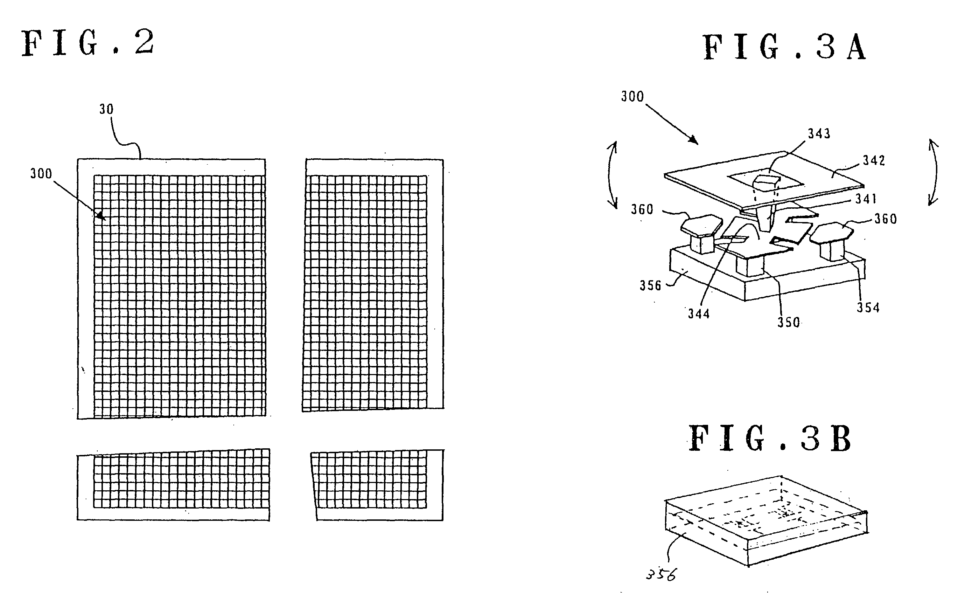

Fig. 2 shows an embodiment of a spatial light modulator/demodulator 30. As shown in the figure, the spatial light modulator/demodulator 30 comprises a plurality of pixels 300 having reflecting surfaces arranged in proximity to a plane, wherein the pixels are arranged in a matrix form. In Fig. 2, the spatial light modulator/demodulator 30 is depicted in such a way that portions between portions including each corner is omitted for an explantory purpose.

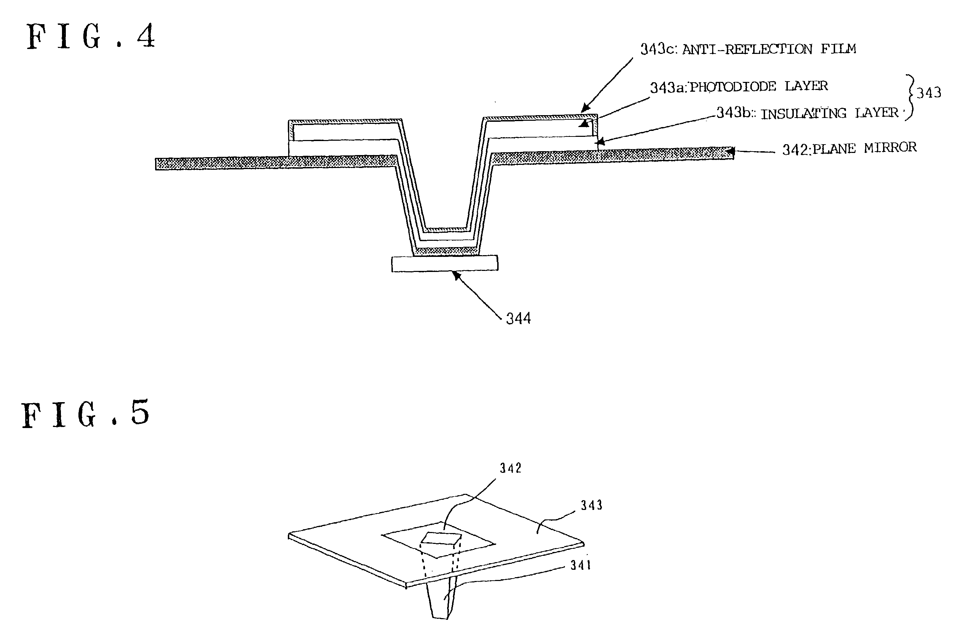

Fig. 3A shows the overall of a monostable pixel 300 of the spatial light modulator/demodulator according to an embodiment of the invention. The pixel 300 is in a superprecise mechanical structure formed by using an LSI semiconductor technology. The pixel 300 has, as shown in Fig. 3A, an aluminum plane mirror 342 serving as a reflecting surface in a rectangular form of an about 16-µm square in the entirety. The plane mirror 342 herein is mere one example, and this is not limitative. A photoelectric converting element 343 is provided in a center of a reflecting surface of the plane mirror 342. As shown in Fig. 4, the photoelectric converting element 343 has a photodiode layer 343a formed on the surface of the plane mirror 342 through an insulating layer 343b. In order to reduce the stray light caused by the reflection light upon the photodiode surface, an anti-reflection film 343c, as a dielectric multi-layered film, may be formed only on the photodiode to prevent reflection. If desired, a light reflective coating can be applied to an exposure portion of the plane mirror 342. The photoelectric converting element 343, although to be arranged nearly in the center of the reflecting surface, may be provided in a reflecting-surface peripheral edge of the plane mirror 342 as shown in Fig. 5.

As shown in Fig. 3A, the plane mirror 342 in an opposite side to the reflecting surface is supported at its center by an aluminum hollow pillar 341. The hollow pillar 341 is supported in the air by a pair of torsion hinges 344. The hinges 344 each are directed from the respective hinge pillars 350 toward each other, to extend along one diagonal line of the plane mirror 342 as shown the figure. The aluminum pillar 341 for the plane mirror 342 is coupled and secured to a center between the hinges 344. The hinges 344 substantially equally divide the plane mirror 342 into two, thereby forming a torsion axis parallel with the diagonal line of the plane mirror 342.

A pair of conductive address electrodes 360 are arranged under the plane mirror 342 with a spacing of several microns from each other to extend along the other diagonal line of the plane mirror 342. The address electrodes 360 are respectively supported by address electrode pillars 354. The torsion hinges 344 and address electrodes 360 are formed of a flexible material, e.g. aluminum, aluminum alloy or titanium/tungsten, in a predetermined thickness by a lithography technique.

The pillars 350, 354 are held on a silicon substrate 356. The address electrode 360 is connected through the address electrode pillar 354 to an address circuit having the CMOS transistors built in the silicon substrate 356 and formed in an underlying layer thereof, as illustrated in Fig. 3B. The address circuit applies an address potential to one of the two address electrodes 360. The plane mirror 342 is connected through the hollow pillar 341 to a bias circuit (not shown) by lines formed on the torsion hinge 344. The bias circuit applies a bias potential to the plane mirror 342. Furthermore, a photoelectric converting element 343 is connected to an output circuit (not shown) through lines provided on the hollow pillar 341 and torsion hinge 344 separately from the bias-potential applying lines. The pillars 350, 354 are formed of an insulating material while the wirings are formed by a via or the like of a conductive material.

In this manner, a drive mechanism is provided on an opposite side of the plane mirror 342 to the reflection surface, to support and drive the plane mirror. This independently causes a change in the angle of the reflection surface with respect to a plane of the reflection surface. It is characterized by comprising a substrate which supports the plane mirror and drive mechanism and carrying an electric circuit that independently controls the drive mechanism according to input image data and is connected to a photoelectric converting element to derive an output thereof.

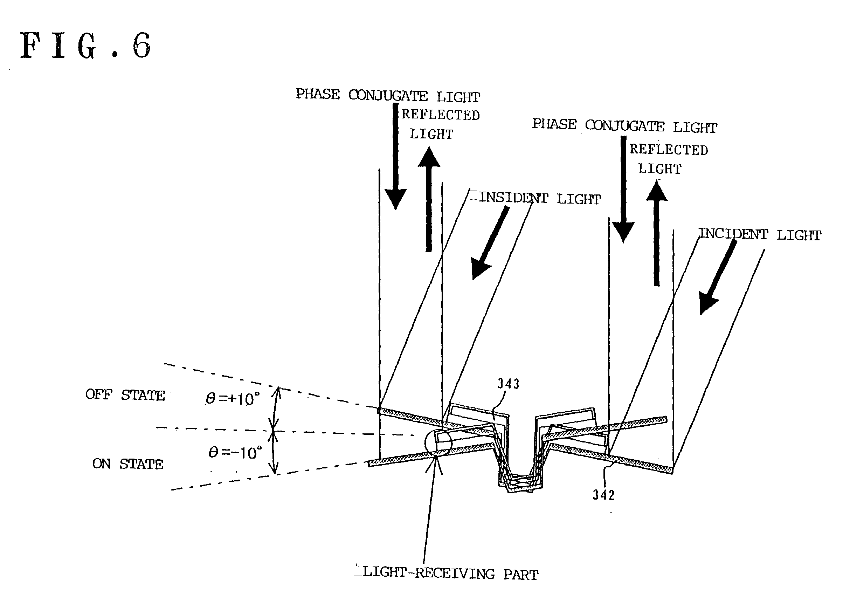

Fig. 6 shows a torsional form of the plane mirror 342 about a torsion axis formed by the hinge 344. The torsion angle θ is a function of a potential applied to one address electrode 360. If a bias voltage is applied to the plane mirror 342 and an address potential is applied to one of the two address electrodes 360, this potential induces an electrostatic induction force at between the plane mirror 342 and the address electrode 360 provided thereunder, causing a torsion angle θ, as shown, in the plane mirror 342. The torsion hinge 344 is rotated, or twisted, in unison with the plane mirror 342, causing a restoring force in the form of mechanical energy. The hinge, when no potential difference is caused, is normally positioned in a plane or non-torsion position.

The hinge torsion is given as a function of a potential applied to the plane mirror 342 at its one address electrode 360. In the analog actuation range, if the plane mirror 342 is twisted by an angle θ, the incident light is deflected over a range of 2θ. As anticipated from the optical characteristic of light, the angular range that incident light is allowed to reflect is 2θ. In the invention, because the plane mirror 342 deflects to an angle, for example, of nearly 10 degrees with linear or non-linear response on the basis of the design, the deflection angle of light is 20 degrees. For example, in the spatial light modulator/demodulator 30 the present embodiment uses an on state of each pixel as θ = - 10° and an off state as θ = + 10°, as shown in Fig. 6.

In this manner, each of the plurality of pixels 300 is well suited for selectively deflect an incident light toward a direction of a function of an electric input. The swing of the plane mirror 342 changes nearly linearly or non-linearly as a function of an input electric signal.

### <Holographic recording/Reproducing Apparatus>

The present invention carries out the input and output of image data not by using a pair of input/output devices, e.g. LCD and CCD, but by using one device, i.e. the foregoing spatial light modulator/demodulator 30. Furthermore, the present invention achieves the relaxation of the positioning accuracy problem by generating a phase conjugate wave toward the spatial light modulator/demodulator 30. The spatial light modulator/demodulator 30 uses several-µm squared microscopic plane mirrors 342, for example, arrayed vertically and horizontally 640 × 480, respectively, in the number having photodiode photoelectric converting elements.

Where photoelectric converting elements, such as photodiodes, in the center of the reflecting surface of the spatial light modulator/demodulator, the reflectivity of a photodiode block during recording is low as compared to that of the plane mirror region. Consequently, a reflection light centrally having a doughnut-formed hollow is recorded as one-pixel information to a holographic memory.

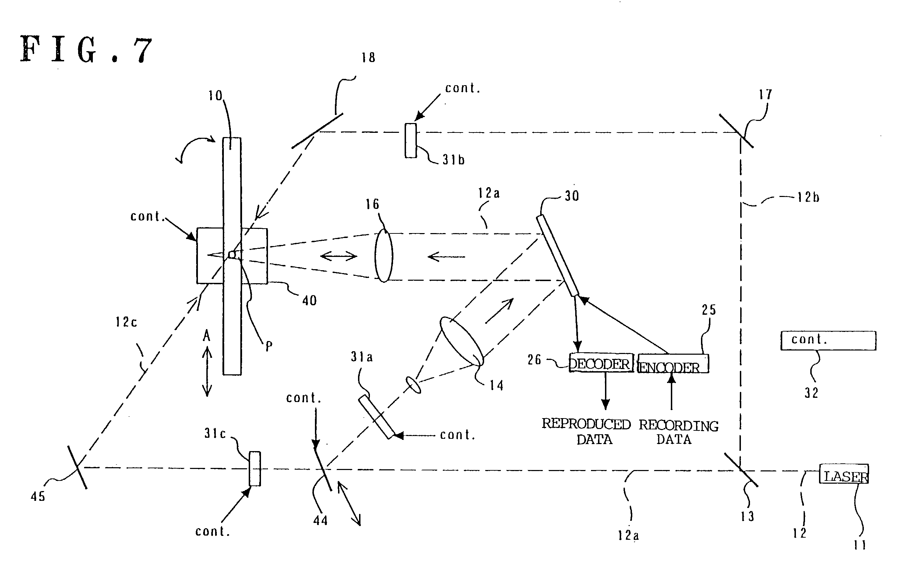

As shown in Fig. 7, the light source 11 for signal light and reference light generation, of e.g. a wavelength 532 nm, is made up by a combination of YAG laser and SHG. The beam of light 12 emitted from the light-beam source 11 is split into a signal light beam 12a and a recording reference light beam 12b by a beam splitter 13. The signal light beam 12a and the recording reference light beam 12b are illuminated to the same position P in a recording medium 10 by way of different optical paths.

On the optical path of the signal light beam 12a, arranged are a movable mirror 44, a shutter 31a, a beam expander 14, a spatial light modulator/demodulator 30 and a Fourier transforming lens 16. The shutters 31a, 31b and 31c are provided to open and close the optical paths of light beams 12a, 12b and 12c. Each shutter is driven to open and close through a driver by a signal forwarded by the controller 32. The beam expander 14 magnifies the beam diameter of the signal light beam 12a reflected upon the movable mirror 44 and passed through the shutter 31a made into a collimated ray to be incident at a predetermined angle on the spatial light modulator/demodulator 30. The spatial light modulator/demodulator 30 is connected to an encoder 25 to receive the electric data in a unit-page series corresponding to two-dimensional pages received by the latter, depending upon which the pixel plane mirrors are independently driven into an on-or-off state correspondingly to a dot-matrix signal. The signal light beam 12a is reflected and optically modulated by the spatial light modulator/demodulator 30, to contain data as a dot-matrix component. Furthermore, the Fourier transforming lens 16 performs Fourier transformation on the dot-matrix component of the signal light beam 12a and focuses it slightly in the front or back of the position P in the recording medium 10.

The spatial light modulator/demodulator 30 is arranged in a conjugation position to receive the phase conjugate wave made into a collimated ray by the Fourier transforming lens 16. The photoelectric converting element of the spatial light modulator/demodulator 30 is connected with a decoder 26. Incidentally, the controller 32 performs control to previously attach the recording medium 10 with a mark corresponding to the kind of photorefractive crystal. If a recording medium 10 is loaded on a movable stage 40 as support means to rotate and move the same, the mark is automatically read by a proper sensor thereby making possible to control the vertical movement and rotation of the recording medium.

The recording reference light beam 12b split from the signal light beam 12a by the beam splitter 13 is guided to the position P in the recording medium 10 by mirrors 17, 18. Between the mirror 17 and the mirror 18 on a light path of the recording reference light, a shutter 31b is arranged to open and close the light path of the recording reference light beam 12b. The shutter 31b is driven to open and close by a signal forwarded by the controller 32 through a driver. The shutter 31b is opened during recording information. The recording reference light beam 12b is guided to the position P in the recording medium 10 to form a light interference pattern of the reference light and signal light in the recording medium 10, thus being information-recorded as a change in refractive index.

On the other hand, in reproducing information, the movable mirror 44 is removed from the light path to cut off the signal light beam 12a by the shutter 31a and the recording reference light beam 12b by the shutter 31b. The shutter 31c only is opened to reflect the signal light beam 12a by the mirror 45 into a reproducing reference light beam 12c. This only is illuminated to the recording medium 10. In a reproducing method with a phase conjugate wave, there is a need to make the recording reference light beam 12b and the reproducing reference light beam 12c in symmetric natures. For the both, symmetrically opposite plane waves are used. Consequently, the reproducing reference light beam 12c illuminates the recording medium 10 at an opposite side of the recording medium 10 through the beam splitter 13, the shutter 31c and the mirror 45. Namely, the reproducing reference light beam 12c is made incident on the recording medium 10 by propagating it coaxially and reverse to the recording reference light beam 12b thereby causing a phase conjugate wave from a refractive-index grating of the light interference pattern. An interference pattern light (phase conjugate wave) appears from a location illuminate by the recording reference light beam 12b. The Fourier transforming lens 16 returns the interference pattern light to the spatial light modulator/demodulator 30. The dot pattern signal of the same is received by the photoelectric converting element of the spatial light modulator/demodulator 30 and then reconverted into an electric digital data signal. If thereafter this is forwarded to the decoder 26, the original data is reproduced.

In this manner, when the reproducing reference light beam 12c is incident at a proper angle on the recording medium 10, so-called a phase conjugation light that signal light travels reverse occurs. The phase conjugation light reaches the spatial light modulator/demodulator 30 while acting to rectify the disorder in a wave surface due to the Fourier transforming lens 16. At this time, all the plane mirrors on the spatial light modulator/demodulator 30 are turned to an on-state. This changes the spatial position of the photoelectric converter of the spatial light modulator/demodulator 30 during recording/reproducing. Accordingly, the image due to the reproduced phase conjugate wave can be demodulated as a light-and-darkness signal into digital image information.

In carrying out angle-multiplexed recording, the recording medium 10 is rotated to change the relative angle between the recording reference light beam 12b and the recording medium 10. In this operation, during recording the shutters 31a, 31b are is opened to record the interference fringe due to the signal light beam 12a modulated by the spatial light modulator/demodulator 30 and the recording reference light beam 12b to the recording medium 10. Completing the recording of the first page, the recording medium 10 is rotated a predetermined amount to change the incident angle of the recording reference light beam 12b on the recording medium 10, thereby recording the second page by the same procedure. Meanwhile, it is possible to structure with a simple rotation feed mechanism that rotates in a helical form for vertical movement by one sector per rotation. Due to this, when the recording medium 10 is rotated and the recording of one sector is completed, the recording medium 10 in an amount of one sector is moved vertically (arrow A) for recording in the similar way. In this manner, angle-multiplexed recording is made by sequential recording. During reproducing, the angle to the reproducing reference light beam 12c is controlled such that the reproducing reference light beam 12c is incident on a position immediately opposite to the recording light beam 12b upon recording the page to be reproduced. The mirrors 18, 45 may be fixed in position such that the both reference light beams are coaxially opposed to each other.

Meanwhile, an expander can be arranged on the light path such that the diameter of one reference light beam is greater than that of the other. If the parallel plate (recording medium 10) is rotated and tilted in the midway of the plane-wave recording reference light beam 12b, there is nothing more than the parallel movement of the optical axis at the front and rear of the plate. Accordingly, during reproducing if only a reproducing reference light beam 12c somewhat greater in beam diameter than the recording reference light beam 12b is incident on the recording medium 10, it is possible to guide into the recording medium 10 a symmetric reproducing reference light beam 12c opposite to the recording reference light beam 12b thus obtaining diffraction light (phase conjugation light as reproduced light). Due to this, a phase conjugation light can be stably obtained even if the transmission position of the recording reference light beam 12b in the recording medium 10 is changed upon carrying out multiplexing due to rotation of the recording medium 10.

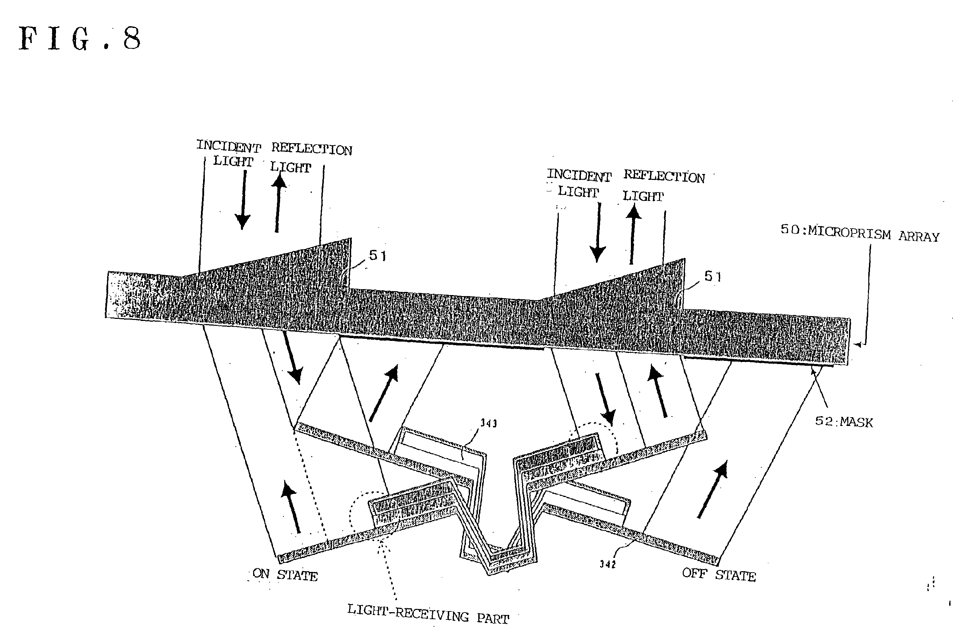

As shown in Fig. 8, a micro-prism array 50 can be arranged with spacing over the entire surface of the spatial light modulator/demodulator 30. Each prism part 51 of the micro-prism array 50 allows an incident light beam and reflection light beam to pass in an on-state of the plane mirror 342, and arranged in a position allowing an incident light beam to be incident on a peripheral edge portion of the photoelectric converting element 343 correspondingly to the plane mirror. In order to absorb stray light in an off-state of the plane mirror 342, a mask 52 can be provided on an inner surface of the micro-prism array 50.

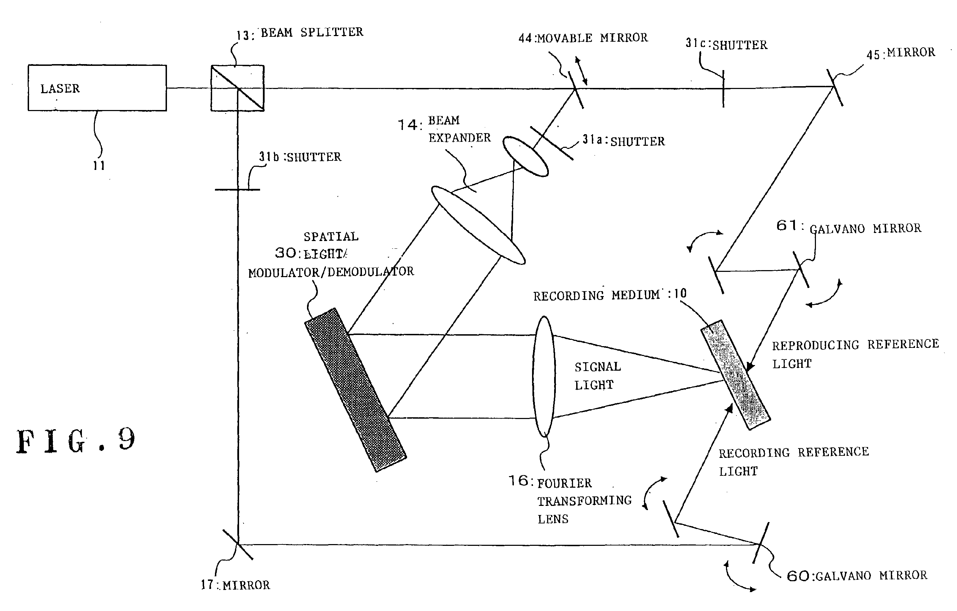

Fig. 9 shows another embodiment of a holographic recording/reproducing apparatus. This structure is similar to the above embodiment in arrangement such as a Fourier transforming lends 16 and a spatial light modulator/demodulator 30 excepting that a pair of galvano mirrors is provided as final incident means in the light path of a recording and reproducing reference light beam to the recording medium 10. In recording digital image information, the movable mirror 44 is inserted in the light path to guide light to the spatial light modulator/demodulator 30. By a pair of galvano mirrors 60, interference is made, in the recording medium 10, between the recording reference light beam 12b at a certain incident angle and the signal light beam 12a modulated by the spatial light modulator/demodulator 30, to carry out holographic recording.

During reproduction, the shutter 31b is closed, the mirror 44 is excluded from the optical path, the shutter 31a is closed and the shutter 31c is opened whereby the light incident on the recording medium 10 is limited to reproducing reference light beam 12c. This reproducing reference light beam 12c adjusts the galvano mirror 61 to a position opposite to the recording reference light beam 12b used upon recording.

During reproduction, by turning all the pixels of the spatial light modulator/demodulator to an on-state, the reproduced light reaches also onto the photoelectric converting element of the photoelectric converting element thus enabling signal reproduction. At this time, as the deflection angle of the plane mirror of the spatial light modulator/demodulator nears 90 degrees, the effective light-receiving area of the photoelectric converting element increases to improve signal level, thus enabling reproduction with higher sensitivity.

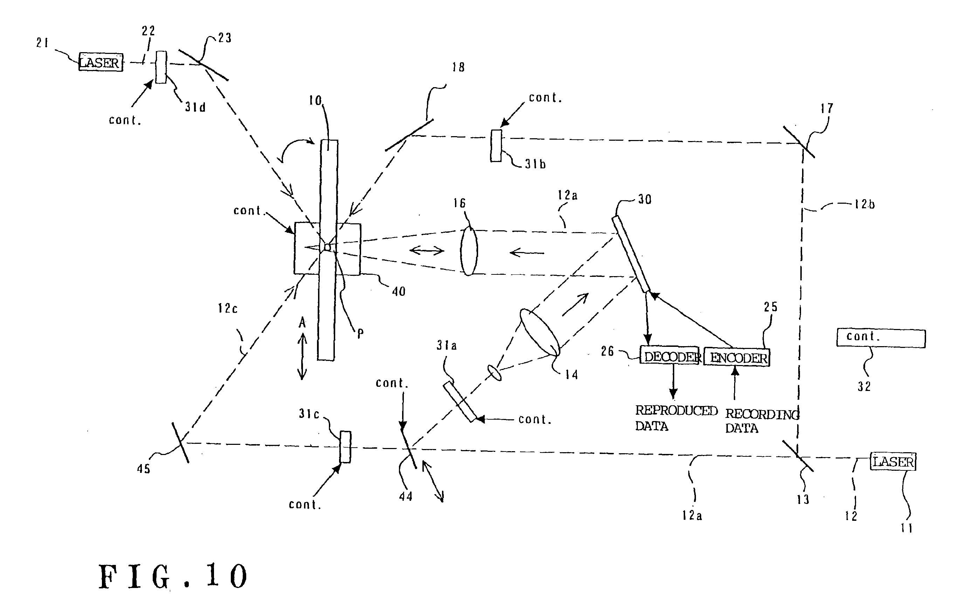

Furthermore, Fig. 10 shows a still another embodiment of so-called a two-color holographic recording/reproducing apparatus. The photorefractive material, e.g. LiNbO₃ added with Tb, is normally colorless and transparent. However, by radiating a ultraviolet ray having a wavelength of nearly 313 nm, visible-light absorption (photochromism) develops to color the illuminated region. Also, on this occasion, because the charge distribution in the medium is made even by the ultraviolet ray, the hologram information in the ultraviolet-ray illuminated region is erased (initialized). If a visible light having a wavelength of 436 nm is illuminated to the colored medium, induction absorption (recording sensitivity) occurs in a near-infrared ray portion of light. At this time the recording sensitivity for the near-infrared light extremely lowers unless illuminating a 436-nm wavelength light, from which this visible light is called as gate light and the previously illuminated ultraviolet light is as pre-illumination light. Also, the near infrared ray used in recording is called signal light and reference light. Accordingly, by separately using gate light and pre-illumination light, recording sensitivity can be developed and initialized at a particular point of the recording medium. Accordingly, two wavelengths of light are used in holographic recording from which this form of recording is called two-color hologram.

The structure of Fig. 10 is similar in arrangement of the Fourier converting lens 16, the spatial light modulator/demodulator 30, etc. to that of the first embodiment, excepting a gate-light pre-illuminating light source 21, shutter 31 and mirror 23 for supplying to the recording medium 10 a light beam having a wavelength different from the wavelength of coherent signal light and recording and reproducing reference light beams. The gate-light pre-illuminating light source 21 is a switchable laser light source for the range of ultraviolet ray or short-wavelength visible light. This light source has sufficient power for developing light-inducing absorption, i.e. coloring, of the recording medium 10 by a illuminating light therefrom. The illuminating light 22 emitted from the gate-light pre-illuminating light source 21 is reflected upon the mirror 23 through the shutter 31d and then illuminated to a holographic recording position of the recording medium 10. The shutter 31d is provided to open and close the optical path of the illuminating light 22. The shutter 31d is driven through a driver by a signal forwarded by the controller 32, to open during the recording of information and close during the reproduction of information.

According to the present invention, during the reproduction reference light is made incident at a position opposite to that during recording thereby causing a phase conjugate wave. The reproduced signal light is caused to travel back through the Fourier transforming lens and return to the photoelectric converting element surface of the spatial light modulator/demodulator. Consequently, the system imperfectness due to optical-system poor alignment is compensated by the effect of phase conjugation, thus eliminating the labor and time in positional adjustment for the optical system.

## Claims

1. A spatial light modulator/demodulator comprising:
a plurality of mirrors having respective reflecting surfaces arranged in proximity to a plane;
photoelectric converting elements each provided on said reflecting surface of said mirror;
a drive mechanism for driving said mirrors to independently change an angle of said reflecting surface to the plane; and
a substrate supporting said mirrors and said drive mechanism, and carrying an electric circuit for independently controlling said drive mechanism according to input image data and connected to said photoelectric converting elements to derive an output thereof.

2. A spatial light modulator/demodulator according to claim 1, wherein said photoelectric converting element is provided nearly at a center of said reflecting surface.

3. A spatial light modulator/demodulator according to claim 1, wherein said photoelectric converting element is provided at an peripheral edge of said reflecting surface.

4. A spatial light modulator/demodulator according to any of claims 1 to 3, wherein an anti-reflection film is provided on said photoelectric converting element.

5. A holographic recording/reproducing apparatus comprising:
a supporting part for attachably holding a recording medium formed of a photorefractive material;
a reference light part for making a coherent recording reference light beam incident on a main surface of said recording medium;
a signal light part for making a coherent signal light beam modulated according to image data incident on said recording medium and intersect the recording reference light beam in an interior thereof, and generating a refractive index grating of a three-dimensional light interference pattern of the signal light beam and recording reference light beam; and
a part for making a coherent reproducing reference light beam propagated coaxially and in a reverse direction to the recording reference light beam incident on said recording medium to cause a phase conjugate wave from the refractive index grating of the light interference pattern;
wherein
said signal light part includes a spatial light modulator/demodulator;
said spatial light modulator/demodulator comprising a plurality of mirrors having respective reflecting surfaces arranged in proximity to a plane, photoelectric converting elements each provided on said reflecting surface of said mirror, a drive mechanism for driving said mirrors to independently change an angle of said reflecting surface to said plane, and a substrate supporting said mirrors and said drive mechanism, and carrying an electric circuit for independently controlling said drive mechanism according to input image data and connected to said photoelectric converting elements to derive an output thereof;
whereby said plurality of mirrors modulates and reflects a coherent light beam according to digital image data to supply the signal light beam, and said photoelectric converting element detects image data focused by the phase conjugate wave.

6. A holographic recording/reproducing apparatus according to claim 5, wherein said recording medium has a parallel plate form.

7. A holographic recording/reproducing apparatus according to claim 5 or 6, wherein said photoelectric converting element is provided nearly at a center of said reflecting surface.

8. A holographic recording/reproducing apparatus according to claim 5 or 6, wherein said photoelectric converting element is provided at a peripheral edge of said reflecting surface.

9. A holographic recording/reproducing apparatus according to claim 5 or 6, wherein an anti-reflection film is provided on said photoelectric converting element.
